# EUROPEAN PATENT APPLICATION

(11) **EP 4 579 966 A1**
(43) Date of publication of application: **02.07.2025**
(21) Application number: 23856921.4
(22) Date of filing: 29.05.2023
(51) Int. Cl.: H01S 5/02255, G01C 3/06, G01S 7/481, G01S 17/10, G02B 26/10, H01L 31/12, H01S 5/02257, H01S 5/024, H01S 5/042, H01S 5/062

(54) **OPTICAL MODULE**

(30) Priority: 24.08.2022 JP 2022133150; 07.11.2022 JP 2022177940
(71) Applicant: SUMITOMO ELECTRIC INDUSTRIES, LTD., Osaka-shi, Osaka 541-0041 (JP)
(72) Inventor: KYONO, Takashi, Osaka-shi, Osaka 541-0041 (JP); MATSUZAKI, Jumpei, Osaka-shi, Osaka 541-0041 (JP); ITO, Shinya, Osaka-shi, Osaka 541-0041 (JP); NAKAMURA, Yuki, Osaka-shi, Osaka 541-0041 (JP)
(74) Representative: Grünecker Patent- und Rechtsanwälte PartG mbB
(86) International application number: PCT/JP2023/019856
(87) International publication number: WO 2024/042803

(57) **Abstract**

This optical module comprises: a laser diode that emits laser light; a scanning unit that includes a reflection mirror for reflecting the laser light and that oscillates the reflection mirror so as to output the laser light to the outside; a protective container that includes a transmission window through which the laser light is transmitted and that surrounds the laser diode and the scanning unit; a control unit that performs control such that the laser light becomes a pulse wave; and an electronic temperature adjustment module that adjusts the temperatures of the laser diode and the scanning unit.

## Description

### TECHNICAL FIELD

The present disclosure relates to an optical module. This application claims priority to Japanese Patent Application No. 2022-133150 filed on August 24, 2022 and Japanese Patent Application No. 2022-177940 filed on November 7, 2022, the entire contents of which are incorporated herein by reference.

### BACKGROUND ART

A light collection optical system is disclosed in which an emitted laser beam is reflected by an object, and the reflected return light is reflected by a reflection surface around a perforated reflecting mirror via a scan mirror and is received by a light receiving element (for example, see Patent Literature 1). Further, an optical module that combines and outputs laser beams is disclosed (for example, see Patent Literature 2).

### CITATION LIST

### PATENT LITERATURE

Patent literature 1: Japanese Unexamined Patent Application Publication No. 2004-170965
Patent literature 2: WO 2019/211943

### SUMMARY OF INVENTION

An optical module according to the present disclosure includes a laser diode configured to emit a laser beam, a scanning portion including a reflecting mirror configured to reflect the laser beam, the scanning portion being configured to output the laser beam to an outside by swinging the reflecting mirror, a protection container having a transmission window through which the laser beam is transmitted, the protection container surrounding the laser diode and the scanning portion, a controller configured to control such that the laser beam becomes a pulse wave, and an electronic temperature adjustment module configured to adjust a temperature of the laser diode and a temperature of the scanning portion.

### BRIEF DESCRIPTION OF THE DRAWINGS

FIG. 1 is a perspective view of an appearance of an optical module according to embodiment 1.
FIG. 2 is a schematic plan view showing the structure of the optical module shown in FIG. 1.
FIG. 3 is a schematic plan view showing the optical module shown in FIG. 1 in a state where the cap is removed.
FIG. 4 is a schematic side view of the optical module shown in FIG. 1.
FIG. 5 is a perspective view showing the appearance of the optical module shown in FIG. 1 in a state where the cap is removed.
FIG. 6 is a schematic plan view of a mirror driving mechanism included in the optical module.
FIG. 7 is a graph showing an example of the output of infrared light driven by pulses.
FIG. 8 is a schematic view showing a state where the spot size of infrared light emitted from the first laser diode is adjusted by the first lens.
FIG. 9 is a graph showing the relationship between the emission area width and the beam diameter at the lens when an angle resolution θ is 0.1°.
FIG. 10 is a schematic plan view showing a state where a cap of the optical module according to the embodiment 2 is removed.
FIG. 11 is a schematic side view of the optical module according to the embodiment 2.
FIG. 12 is a perspective view showing the appearance of the optical module shown in FIG. 10 in a state where the cap is removed.
FIG. 13 is a schematic plan view of the optical module according to the embodiment 3.
FIG. 14 is a schematic plan view showing a state where a cap of the optical module according to the embodiment 3 is removed.
FIG. 15 is a perspective view of the appearance of the optical module shown in FIG. 14.
FIG. 16 is a schematic plan view showing a state where a cap of the optical module according to the embodiment 4 is removed.
FIG. 17 is a perspective view of the optical module shown in FIG. 16.
FIG. 18 is a schematic perspective view showing an optical module in which a convex lens for condensing light is fitted in an incidence window.
FIG. 19 is a schematic plan view of the optical module shown in FIG. 18.

### DETAILED DESCRIPTION

### [Problems to be Solved by Present Disclosure]

When a laser diode that emits a laser beam is used as a distance measuring sensor, the laser beam is controlled to become a pulse wave. There is a need to simplify the design of the control circuit used to emit the pulse wave and to stabilize the output of the laser diode.

Thus, it is an object to provide an optical module capable of stabilizing the output of a laser diode while facilitating circuit design.

### [Advantageous Effects of Present Disclosure]

According to such an optical module, it is possible to stabilize the output of the laser diode while facilitating the circuit design.

### [Description of Embodiments of Present Disclosure]

First, embodiments of the present disclosure will be listed and described.
(1) An optical module according to the present disclosure includes a laser diode configured to emit a laser beam, a scanning portion including a reflecting mirror configured to reflect the laser beam, the scanning portion being configured to output the laser beam to an outside by swinging the reflecting mirror, a protection container having a transmission window through which the laser beam is transmitted, the protection container surrounding the laser diode and the scanning portion, a controller configured to control such that the laser beam becomes a pulse wave, and an electronic temperature adjustment module configured to adjust a temperature of the laser diode and a temperature of the scanning portion.

According to such an optical module, the optical module can be used as a distance measuring sensor by using a laser beam of a pulse wave emitted from the laser diode. That is, the distance to the object may be calculated and measured based on the time for emitting the laser beam by pulse driving, the time from the emission of the laser beam of pulse wave from the laser diode to the reception of the reflected light of the object, and the speed of the laser beam which is previously known. In this case, the laser beam emitted from the scanning portion is scanned, and thus a two-dimensional distance can be measured.

In a laser diode that emits a laser beam of a pulse wave, when a drive cycle of the laser diode is shortened while maintaining a small duty ratio in order to secure stable drive of the laser diode, a pulse width is reduced. When the pulse width becomes extremely small, it becomes difficult to design a driving circuit for controlling the pulse wave. When the pulse width is increased to some extent, the design of the driving circuit is facilitated, but the duty ratio is increased. Then, the heat generation of the laser diode increases, and it is difficult to stably output the laser beam from the laser diode.

According to the optical module of the present disclosure, since the electronic temperature adjustment module for adjusting the temperature of the laser diode is included, the electronic temperature adjustment module is driven during the operation of the optical module, and thus the temperature can be controlled by reducing the heat generation of the laser diode. Then, the output from the laser diode can be stabilized while the pulse width is increased to some extent. Further, since the heat generation of the laser diode can be reduced, the output of the laser diode can be increased from the viewpoint of improvement of the measurement distance or the like. Furthermore, the electronic temperature adjustment module also adjusts the temperature of the scanning portion, so that the operation of the scanning portion can be stabilized regardless of the environmental temperature. Thus, according to the optical module, it is possible to stabilize the output of the laser diode while facilitating the circuit design.

(2) In the above (1), a duty ratio of the pulse wave may be more than 0.1% and 10% or less. In this way, the pulse width can be increased while the peak of the output value of the pulse wave is kept within the restriction of the eye safe (class 1). The duty ratio of the pulse wave is, for example, 0.2% with a laser diode drive frequency of 100 kHz and a pulse width of 20 nanoseconds, or 0.5% with a laser diode drive frequency of 100 kHz and a pulse width of 50 nanoseconds.

(3) In the above (1) or (2), the laser diode may include a plurality of laser diodes. The optical module may further include a filter configured to combine laser beams emitted from the plurality of laser diodes. In this way, it is possible to combine a plurality of laser diodes to achieve a high output, and it is possible to increase the measurement distance and improve the SN ratio.

(4) In any one of the above (1) to (3), at least one of the plurality of laser diodes may be configured to emit infrared light. Even when the heat generation of the laser diode emitting infrared light is large, the output from the laser diode can be stable.

(5) In any one of the above (1) to (4), at least one of the plurality of laser diodes may be configured to emit visible light. In this way, the optical module can be used for distance measurement under water.

(6) In any one of the above (1) to (5), the optical module may further include a lens configured to adjust a spot size of the laser beam. In this way, the laser beam having a desired spot size can be emitted from the optical module.

(7) In any one of the above (1) to (6), an emission area width of the laser beam of the laser diode may be 50 µm or less. In this way, the spot size can be reduced, the optical loss in the scanning mirror can be reduced, and the laser beam can be efficiently emitted. Further, a multi-mode laser diode can be used, and a high output can be achieved.

(8) In any one of the above (1) to (7), an emission area width of the laser beam of the laser diode may be 30 µm or less. In this way, it is possible to emit the laser beam more efficiently.

(9) In any one of the above (1) to (8), the optical module may further include a photodiode configured to receive reflected light, the reflected light being the laser beam that is output to an outside of the protection container and reflected by an object. In this way, it is possible to calculate the difference between the time when the laser beam emitted by the laser diode is emitted and the time when the laser beam received by the photodiode is received.

(10) In the above (9), the photodiode may be configured to receive reflected light from the reflecting mirror. In this way, the apparatus configuration can be made more compact, and miniaturization can be realized.

(11) In the above (9) or (10), the protection container may be provided with an incidence window on which the reflected light is made incident. A convex lens may be fitted to the incidence window, the convex lens being configured to condense the reflected light and cause the reflected light to be received by a light reception surface of the photodiode. According to such a configuration, the reflected light from the object can be condensed by the convex lens and efficiently received by the light reception surface of the photodiode, and thus the accuracy of the distance to be measured can be further improved.

(12) In any one of the above (9) to (11), a temperature of the photodiode may be adjusted by the electronic temperature adjustment module. This makes it possible to limit the change in performance of the photodiode due to temperature, and to increase the accuracy of the distance to be measured.

(13) In any one of the above (9) to (12), the controller may be configured to calculate a distance to the object based on a time when the laser beam is emitted and a time when the photodiode receives the reflected light. In this way, the controller can calculate the distance to the object based on the difference between the time when the laser beam is emitted by the laser diode and the time when the photodiode receives the reflected light, and the speed of the laser beam which is previously known. Thus, the distance can be measured simply and accurately while limiting the influence of the environmental light.

### [Details of Embodiments of Present Disclosure]

Next, embodiments of the optical module of the present disclosure will be described with reference to the drawings. In the drawings, the same or corresponding parts are denoted by the same reference characters, and description thereof will not be repeated.

### (Embodiment 1)

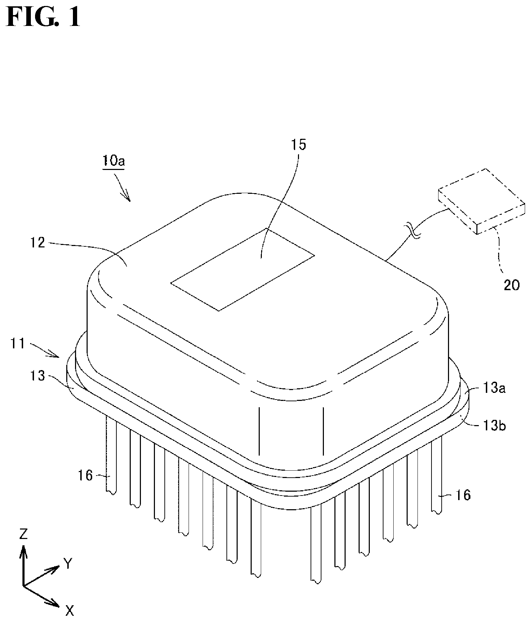

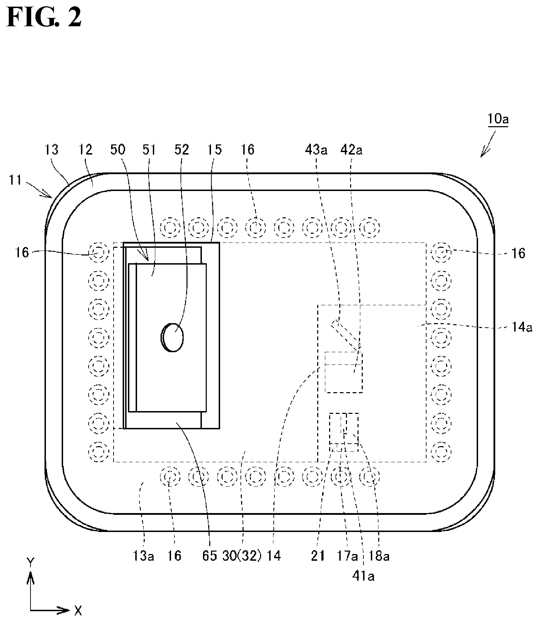

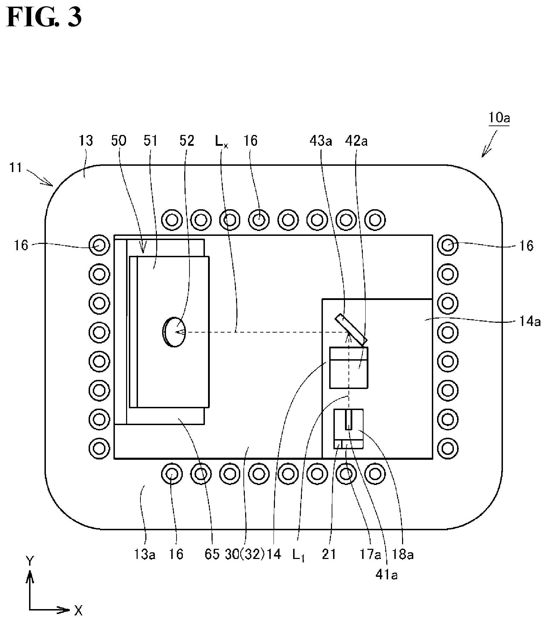

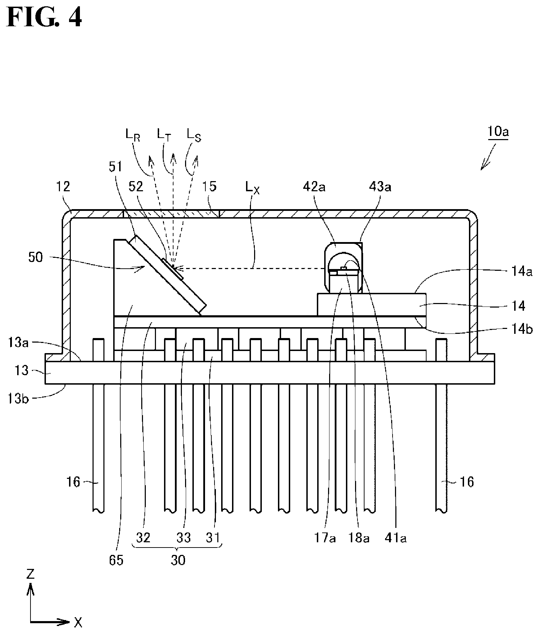

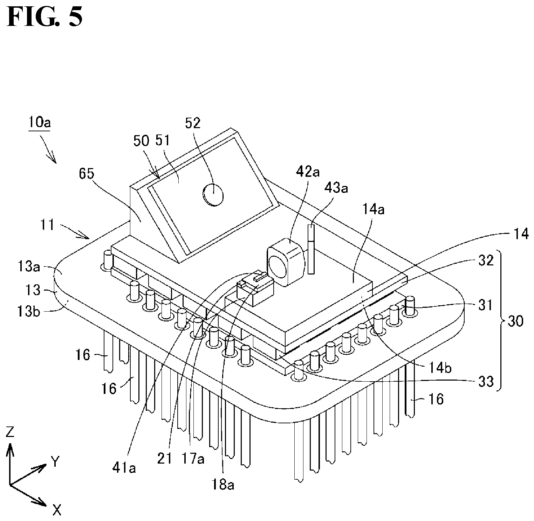

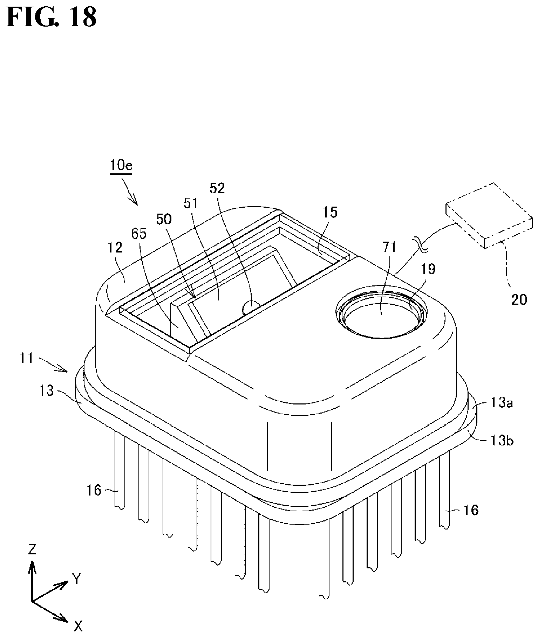

An optical module according to embodiment 1 of the present disclosure will be described. FIG. 1 is a perspective view of an appearance of an optical module according to embodiment 1. FIG. 2 is a schematic plan view showing the structure of the optical module shown in FIG. 1. FIG. 3 is a schematic plan view showing the optical module shown in FIG. 1 in a state where a cap described later is removed. FIG. 4 is a schematic side view of the optical module shown in FIG. 1. In FIG. 4, the cap is shown in a state cut along an X-Z plane where a transmission window described later is located. FIG. 5 is a perspective view showing the appearance of the optical module shown in FIG. 1 in a state where the cap removed. In FIG. 1, a controller described later is schematically shown by a one dot chain line. In addition, the controller is not shown in FIG. 1 and FIG. 18 described later.

Referring to FIGS. 1, 2, 3, 4, and 5, an optical module 10a includes a base portion 11, a cap 12 as a protection container, a controller 20, a laser diode 41a (first laser diode 41a), a lens 42a (first lens 42a), a filter 43a (first filter 43a), and a mirror driving mechanism 50 as a scanning portion including a scanning mirror 52 for scanning light. In the present embodiment, base portion 11 includes a support plate 13 having a flat plate shape, a base plate 14 having a flat plate shape, an electronic cooling module 30 as an electronic temperature adjustment module, a block portion (a first block portion 17a), a mount portion (a first mount portion 18a), and a base 65 described later. The thickness direction of support plate 13 is indicated by the Z direction.

Cap 12 is a lid portion welded to support plate 13. The components arranged on support plate 13 are surrounded and sealed by support plate 13 and cap 12. That is, cap 12 as a protection container surrounds first laser diode 41a, first lens 42a, first filter 43a, and mirror driving mechanism 50.

Support plate 13 has a rectangular shape of which four corners are rounded when viewed in the Z direction. Specifically, support plate 13 is configured such that the length in the X direction is longer than the length in the Y direction.

Support plate 13 includes a first surface 13a perpendicular to the thickness direction and a second surface 13b located opposite to first surface 13a in the thickness direction. First surface 13a and second surface 13b are each a surface perpendicular to the Z direction, that is, a surface parallel to the X-Y plane. Cap 12 is arranged to be in contact with first surface 13a. Cap 12 is provided with a transmission window 15 through which the light transmits. First laser diode 41a, first lens 42a, first filter 43a, and mirror driving mechanism 50 arranged on support plate 13 are hermetically sealed by cap 12. Transmission window 15 is provided over cap 12, that is, at a position facing first surface 13a when cap 12 is attached to support plate 13. A plurality of lead pins 16 are installed on support plate 13 so as to penetrate support plate 13, and protrude from first surface 13a and second surface 13b.

Base plate 14 includes a first main surface 14a and a second main surface 14b as two main surfaces perpendicular to the thickness direction. First main surface 14a and second main surface 14b are each a surface perpendicular to the Z direction, that is, a surface parallel to the X-Y plane.

Electronic cooling module 30 adjusts the temperature of each component on electronic cooling module 30. Electronic cooling module 30 is also called a thermo-electric cooler (TEC), and includes a heat dissipation plate 31, a heat absorption plate 32, and a plurality of semiconductor pillars 33. Electronic cooling module 30 is arranged on support plate 13, specifically, on first surface 13a of support plate 13. Base plate 14 is arranged on electronic cooling module 30. That is, electronic cooling module 30 is arranged so as to be sandwiched between support plate 13 and base plate 14 in the Z direction. In electronic cooling module 30, heat dissipation plate 31 is arranged to be in contact with first surface 13a of support plate 13. Heat absorption plate 32 is arranged to contact second main surface 14b of base plate 14. Support plate 13 and heat dissipation plate 31, and base plate 14 and heat absorption plate 32 are bonded to each other with a bonding material (not shown). The plurality of semiconductor pillars 33 are configured by Peltier elements, and are arranged between heat dissipation plate 31 and heat absorption plate 32 so as to be arranged at intervals in the X direction and the Y direction. The plurality of semiconductor pillars 33 are connected to heat dissipation plate 31 and heat absorption plate 32, respectively. By energizing electronic cooling module 30, the temperature of each component on electronic cooling module 30 can be adjusted. By adjusting the current supplied to electronic cooling module 30, it is easy to maintain each component on electronic cooling module 30 at a constant temperature, specifically, for example, 35°C for a long period of time.

First block portion 17a has a rectangular parallelepiped shape. First block portion 17a is arranged on first main surface 14a of base plate 14. First block portion 17a is configured such that the length in the X direction is shorter than the length in the Y direction when viewed in the Z direction. First mount portion 18a included in base portion 11 is arranged to be in contact with first block portion 17a. First mount portion 18a is arranged on first block portion 17a.

First laser diode 41a emits a first laser beam L₁. First laser beam L₁ is, for example, infrared light. The wavelength emitted from first laser diode 41a may be, for example, in a range of 700 nm or more and less than 1100 nm (first range) or in a range of 1100 nm to 1800 nm (second range). As the wavelength is longer, the maximum radiation level of the laser beam line that is allowed for eyes is greater. That is, the maximum radiation level of the laser beam line that is allowed for eyes is greater for the laser beam in the second range than for that in the second range. Thus, the power output of the laser beam in the second range can be greater. For the first range, typically, 830 nm, 850 nm, 905 nm, and 940 nm are selected. For the second range, typically, 1310 nm and 1550 nm are selected.

First laser diode 41a is mounted on first mount portion 18a. First laser diode 41a emits first laser beam L₁ in the Y direction (the direction of an arrow Y). First laser diode 41a is a so-called multi-mode laser diode. First laser diode 41a has an emission area having a long width in the X direction on the emitting end surface, and emits first laser beam L₁ from the emission area. The emission area width of first laser diode 41a is 50 µm or less. Specifically, the emission area width of first laser diode 41a is 30 µm. The emission area width is the distance in the X direction of the current injection region defined by the shape of the electrode and the processing of the semiconductor constituting first laser diode 41a.

First lens 42a is mounted above heat absorption plate 32, specifically, on first main surface 14a of base plate 14. First lens 42a converts the spot size of the light emitted from first laser diode 41a. Specifically, first lens 42a is arranged in the emitting direction of first laser beam L₁, and converts first laser beam L₁ into collimated light. In this way, first lens 42a adjusts the spot size of first laser beam L₁ emitted from first laser diode 41a.

First filter 43a is mounted above heat absorption plate 32, specifically, on first main surface 14a of base plate 14. First filter 43a is arranged in the emission direction of the light emitted from first laser diode 41a. First filter 43a reflects first laser beam L₁ in the X direction (the direction opposite to an arrow X) (L_{X} in FIGS. 3 and 4).

Optical module 10a includes a thermistor 21. Thermistor 21 is arranged on first block portion 17a. Thermistor 21 is arranged in the vicinity of first laser diode 41a. Thermistor 21 can be used to detect the temperature of first block portion 17a and thus the temperature of the region on heat absorption plate 32. The temperature detected by thermistor 21 is used for temperature adjustment by electronic cooling module 30. Thermistor 21 may be arranged on base 65 on which mirror driving mechanism 50 to be described later is arranged. When optical module 10a is used in a situation in which the temperature adjustment of mirror driving mechanism 50 by electronic cooling module 30 is considered to be important, thermistor 21 may be arranged on base 65. In addition, thermistor 21 may be arranged on electronic cooling module 30, specifically, on heat absorption plate 32, and first laser diode 41a and mirror driving mechanism 50 may be adjusted to an appropriate temperature by electronic cooling module 30.

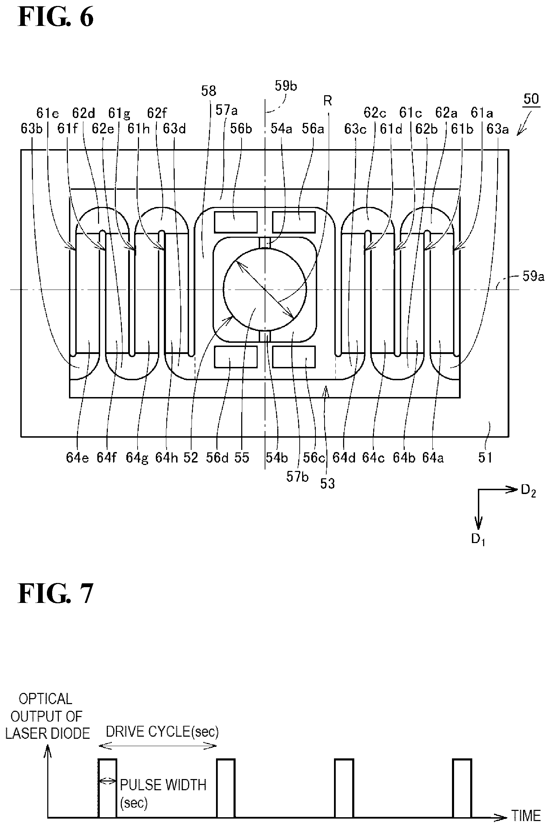

Mirror driving mechanism 50 included in optical module 10a is arranged on electronic cooling module 30, specifically, on heat absorption plate 32. FIG. 6 is a schematic plan view of mirror driving mechanism 50 included in optical module 10a. In the drawings other than FIG. 6, mirror driving mechanism 50 is shown in a simplified manner.

As shown in FIG. 6, mirror driving mechanism 50 includes a frame portion 51, disk-shaped scanning mirror 52 having a reflection surface 55, and a support portion 53 for supporting scanning mirror 52. Scanning mirror 52 is configured to be swingable about a first swing axis 59a and a second swing axis 59b, which are indicated by one dot chain lines. First swing axis 59a is a virtual axis extending along a D₂ direction in FIG. 6, and second swing axis 59b is a virtual axis extending along a D₁ direction in FIG. 6. The D₁ direction and the D₂ direction are perpendicular to each other. In assembling optical module 10a, mirror driving mechanism 50 is attached in the direction indicated by an arrow D₁, which is the direction indicated by arrow X in FIG. 1 and the like, and in the direction indicated by an arrow D₂, which is the direction indicated by arrow Y in FIG. 1 and the like.

Frame portion 51 is provided with a first through hole 57a, and support portion 53 for supporting scanning mirror 52 is provided in first through hole 57a. Support portion 53 is provided with a second through hole 57b. Scanning mirror 52 is supported by a pair of thin rod-like shaft portions 54a and 54b so as to be swingable around second swing axis 59b indicated by a one dot chain line in second through hole 57b. When scanning mirror 52 swings around second swing axis 59b, four piezoelectric elements 56a, 56b, 56c, and 56d attached to support portion 53 are used.

Support portion 53 is plate-shaped. Support portion 53 includes a plurality of first portions 61a, 61b, 61c, 61d, 61e, 61f, 61g, and 61h each extending along the D₁ direction. Support portion 53 further includes a plurality of second portions 62a, 62b, 62c, 62d, 62e, and 62f that connect adjacent first portions 61a to 61h, respectively. Support portion 53 further includes coupling portions 63a and 63b that couple support portion 53 and frame portion 51. Support portion 53 further includes an attachment portion 58 to which scanning mirror 52 is attached with shaft portions 54a and 54b. Support portion 53 further includes connecting portions 63c and 63d that connect first portions 61d and 61h and attachment portion 58. Second portions 62a to 62f alternately connect the first ends and the second ends of the two ends in the longitudinal direction of adjacent first portions 61a to 61h. Piezoelectric elements 64a, 64b, 64c, 64d, 64e, 64f, 64g, and 64h are respectively mounted on first portions 61a to 61h. When scanning mirror 52 swings around first swing axis 59a, piezoelectric elements 64a to 64h are used. As piezoelectric elements 56a to 56d and 64a to 64h, for example, piezoelectric elements are used. Support portion 53 has a so-called meander structure.

Mirror driving mechanism 50 swings scanning mirror 52 around first swing axis 59a and second swing axis 59b as the center axis of swing while adjusting the voltage supplied to piezoelectric elements 56a to 56d and 64a to 64h. The diameter of scanning mirror 52 is indicated by a diameter R in FIG. 6.

Mirror driving mechanism 50 is arranged on base 65. Base 65 is formed of a single triangular prism-shaped component. In this case, the mounting surface on which mirror driving mechanism 50 is mounted is inclined with respect to first surface 13a. That is, the reflection surface of scanning mirror 52 is provided to be inclined with respect to the optical axis of first laser beam L₁ emitted from first laser diode 41a.

Controller 20 controls the pulse driving by first laser diode 41a, electronic cooling module 30, and mirror driving mechanism 50. That is, first laser beam L₁ emitted from first laser diode 41a is controlled to become a pulse wave. FIG. 7 is a graph showing an example of the output of first laser beam L₁ driven by pulses. In FIG. 7, the vertical axis represents the optical output of the laser, and the horizontal axis represents time. Referring to FIG. 7, controller 20 periodically transmits a signal to control the operation of first laser diode 41a so that a pulse wave having a predetermined pulse width is emitted from first laser diode 41a. The duty ratio is a value obtained by dividing the pulse width by the drive cycle. In the present embodiment, the duty ratio is more than 0.1% and 10% or less. Specifically, the duty ratio is 0.5%.

Scanning lights L_{R}, L_{S}, and L_{T} reflected by swinging scanning mirror 52 are emitted from transmission window 15. This is shown in FIG. 4. First laser beam L₁ is reflected by the object and becomes reflected light. Controller 20 can measure the distance to the object based on the time when first laser beam L₁ is emitted, the time until the reflected light is received, and the speed of first laser beam L₁ (infrared light in this case) which is previously known. In this case, mirror driving mechanism 50 scans first laser beam L₁, and thus a two-dimensional distance can be measured.

According to optical module 10a of the present disclosure, since electronic cooling module 30 for adjusting the temperature of first laser diode 41a is included, electronic cooling module 30 is driven during the operation of optical module 10a, and the temperature can be controlled by reducing the heat generation of first laser diode 41a. Then, the output from first laser diode 41a can be stabilized while the pulse width is increased to some extent. Further, since the heat generation of first laser diode 41a can be reduced, the output of first laser diode 41a can be increased from the viewpoint of improvement of the measurement distance or the like. Furthermore, electronic cooling module 30 also adjusts the temperature of mirror driving mechanism 50, so that the operation of mirror driving mechanism 50 can be stabilized regardless of the environmental temperature. For example, the deflection angle of scanning mirror 52 can be stabilized. Thus, according to optical module 10a, it is possible to stabilize the output of first laser diode 41a while facilitating the circuit design.

In the present embodiment, first lens 42a is provided to adjust the spot size of first laser beam L₁ emitted from first laser diode 41a. Thus, first laser beam L₁ having a desired spot size can be emitted from optical module 10a.

In the present embodiment, the emission area width of first laser beam L₁ of first laser diode 41a is 50 µm or less. Thus, the spot size can be reduced, the optical loss in scanning mirror 52 can be reduced, and first laser beam L₁ can be efficiently emitted. Further, a multi-mode laser diode can be used, and a high output can be achieved.

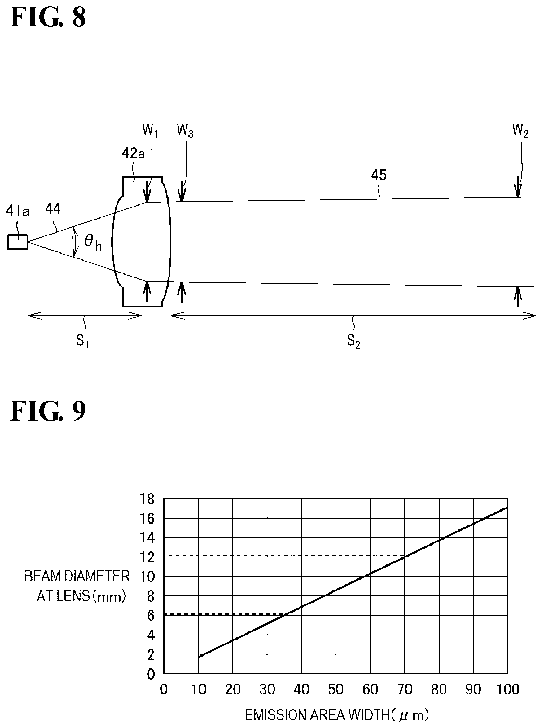

FIG. 8 is a schematic view showing a state where the spot size of first laser beam L₁ emitted from first laser diode 41a is adjusted by first lens 42a. Referring to FIG. 8, a first laser beam 44 emitted from first laser diode 41a is a diffused light and reaches first lens 42a located at a distance of a lens focal point distance S₁. When the beam diameter that is within the effective diameter of first lens 42a and whose spot size is adjusted is denoted by a diameter W₁, a first laser beam 45 that has passed through first lens 42a has a beam diameter W₂ corresponding to beam diameter W₁ at first lens 42a at a distance S₂. As distance S₂ that can be measured, for example, a distance within 100 m is selected for industrial use, and a distance from 200 m to 300 m is selected for in-vehicle use.

When the beam diameter at scanning mirror 52 is denoted by a diameter W₃, the optical loss at scanning mirror 52 can be reduced when diameter W₃ is equal to or smaller than diameter R of scanning mirror 52. Beam diameter W₃ at scanning mirror 52 is approximated to beam diameter W₁ at first lens 42a, and this value is expressed by the following approximate expression. Scanning mirror diameter R ≈ beam diameter W1 at lens ≈ 2 × emission area width × tan (θh/2)/tanθ

An angle θₕ represents the emission beam radiation angle in the emission area width direction of first laser diode 41a, and is shown in FIG. 8. An angle θ represents angle resolution. Realistic diameter R of scanning mirror 52 may be 10 mm or less.

FIG. 9 is a graph showing the relationship between the emission area width and the beam diameter at the lens when angle resolution θ is 0.1°. In FIG. 9, the vertical axis represents the beam diameter at the lens, and the horizontal axis represents the emission area width. Also referring to FIG. 9, when the emission area width is 70 µm, the beam diameter at the lens is 12 mm. Then, for example, when 10 mm is selected as diameter R of scanning mirror 52, beam diameter W₂ exceeds diameter R of scanning mirror 52. This is a problem that becomes particularly conspicuous when first lens 42a and mirror driving mechanism 50 are accommodated in a protection container as in optical module 10a of the present disclosure, and a configuration that reduces optical loss while achieving miniaturization of components that directly lead to miniaturization of the optical module is required.

By setting the emission area width of first laser beam L₁ of first laser diode 41a to 50 µm or less, the beam diameter at the lens can be 10 mm or less, and optical loss at scanning mirror 52 can be reduced. Thus, first laser beam L₁ can be efficiently emitted.

### (Embodiment 2)

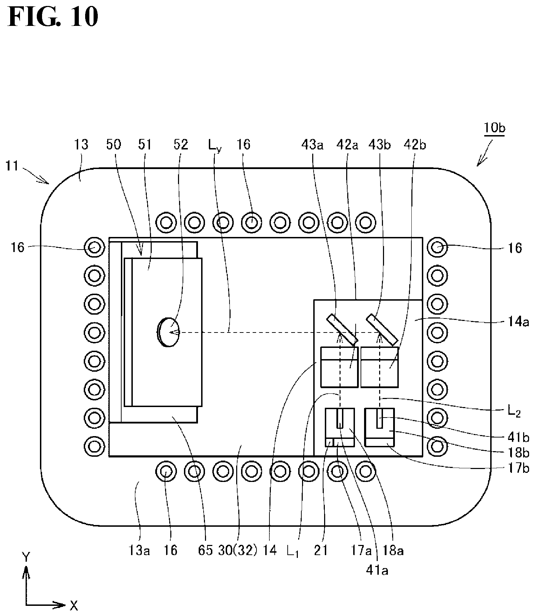

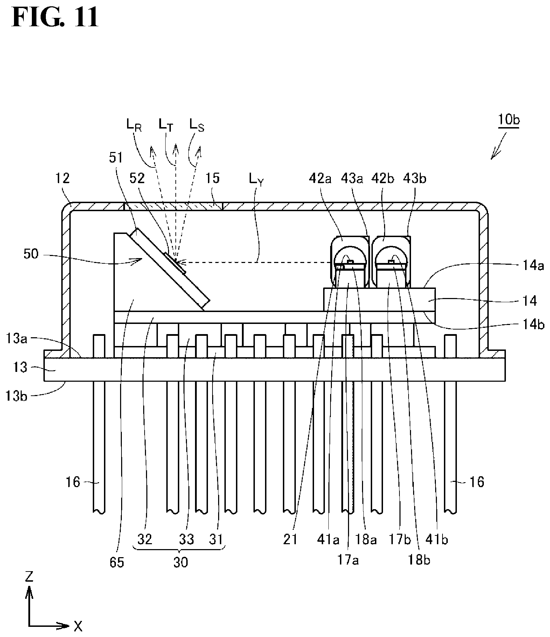

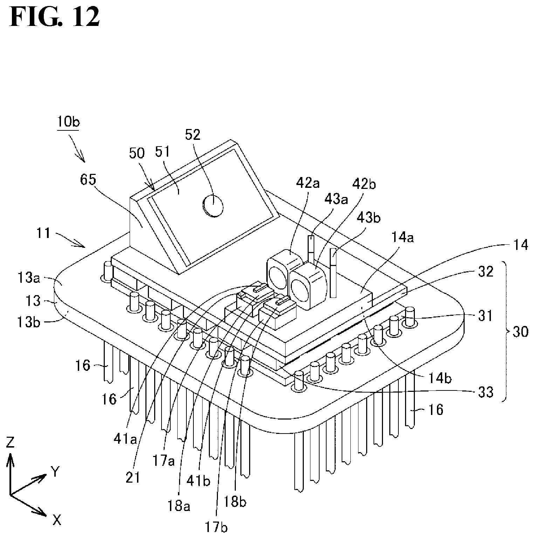

An embodiment 2, which is another embodiment, will be described. FIG. 10 is a schematic plan view showing a state where a cap of the optical module according to the embodiment 2 is removed. FIG. 11 is a schematic side view of the optical module according to the embodiment 2. FIG. 12 is a perspective view showing the appearance of the optical module shown in FIG. 10 in a state where the cap is removed. The optical module according to the embodiment 2 basically has the similar configuration as that of the embodiment 1, and provides the same effects. However, the optical module of the embodiment 2 is different from the optical module of the embodiment 1 in that the number of laser diodes, lenses, and filters is increased.

Referring to FIGS. 10, 11, and 12, an optical module 10b of the embodiment 2 includes a laser diode 41b (second laser diode 41b), a lens 42b (second lens 42b), and a filter 43b (second filter 43b). Second lens 42b adjusts the spot size of a second laser beam L₂ emitted from second laser diode 41b. Second filter 43b reflects second laser beam L₂ emitted from second laser diode 41b. Second laser diode 41b emits second laser beam L₂ by pulse driving. Second laser diode 41b emits second laser beam L₂ in the Y direction (the direction of arrow Y). Second laser beam L₂ is, for example, infrared light. Here, the wavelength of second laser beam L₂ may be different from the wavelength of first laser beam L₁. For example, the wavelength of first laser beam L₁ may be 830 nm, and the wavelength of second laser beam L₂ may be 940 nm.

Controller 20 controls the pulse driving of first laser beam L₁ to be the same as the pulse driving of second laser beam L₂. That is, the pulse waves are emitted from both first laser diode 41a and second laser diode 41b at the same timing. First filter 43a is a wavelength selective filter, which reflects first laser beam L₁ and transmits second laser beam L₂. That is, first laser beam L₁ of the wavelength of 830 nm is reflected, and second laser beam L₂ of the wavelength of 940 nm is transmitted. In this way, first filter 43a combines first laser beam L₁ and second laser beam L₂ to form a combined beam L_{Y}. Combined beam Ly thus formed travels in the Y direction and is incident on scanning mirror 52.

According to the present embodiment, it is possible to combine a plurality of laser diodes to achieve a high output, and it is possible to increase the measurement distance and to improve the SN ratio.

In the above embodiment, the wavelength of first laser beam L₁ may be 1310 nm, and the wavelength of second laser beam L₂ may be 1550 nm. Alternatively, the wavelength of first laser beam L₁ may be 905 nm, and the wavelength of second laser beam L₂ may be 1550 nm. That is, the laser beams emitted from the laser diodes may be combined with a difference in wavelength.

In the above embodiment, the polarization direction of first laser beam L₁ and the polarization direction of second laser beam L₂ may be perpendicular to each other. In this case, a 1/2 wavelength plate is prepared and arranged in front of or behind second lens 42b. The polarization direction may be rotated by 90 degrees in this way, and the light beams may be combined by first filter 43a. Further, for example, a cubic polarization beam splitter may be arranged instead of first filter 43a. With this configuration, even when the wavelength of first laser beam L₁ and the wavelength of second laser beam L₂ are the same, first filter 43a can combine the beams to increase the output.

Referring again to FIG. 9, it is desirable to set the emission area width to 50 µm or less in order to set the beam diameter at the lens to 10 mm or less, but it is highly difficult to increase the diameter of scanning mirror 52 from the viewpoint of the deflection angle and durability. That is, the beam diameter at the lens may be, for example, 6 mm or less. Then, the emission area width may be 30 µm or less. As the emission area width becomes shorter, the output of the laser diode decreases, and the measurable distance becomes shorter.

However, in the present embodiment, two laser diodes are combined. Thus, the output can be improved, that is, the output can be increased. In this case, for example, a plurality of single-mode laser diodes may be mounted and used, with the single-mode laser diode having an emission area width of a laser beam of the laser diode of 5 µm or less.

In the above embodiment, the number of laser diodes is two, but the number of laser diodes is not limited to this, and may be three or more. An emission area width of a laser beam of the laser diode may be 10 µm or more. This makes it possible to ensure an output effective for distance measurement without increasing the number of laser diodes excessively.

### (Embodiment 3)

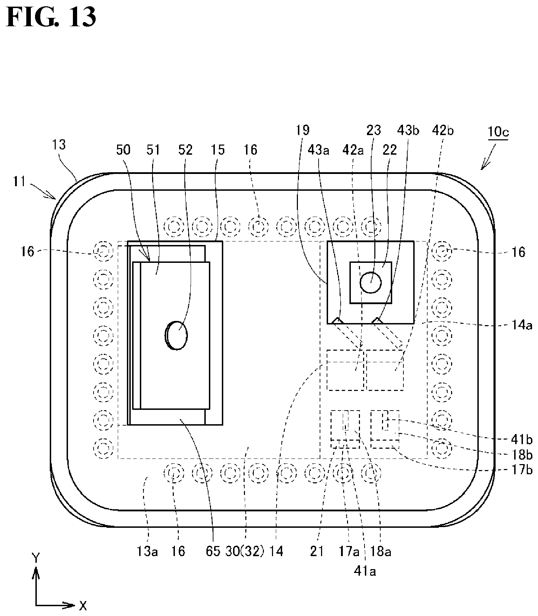

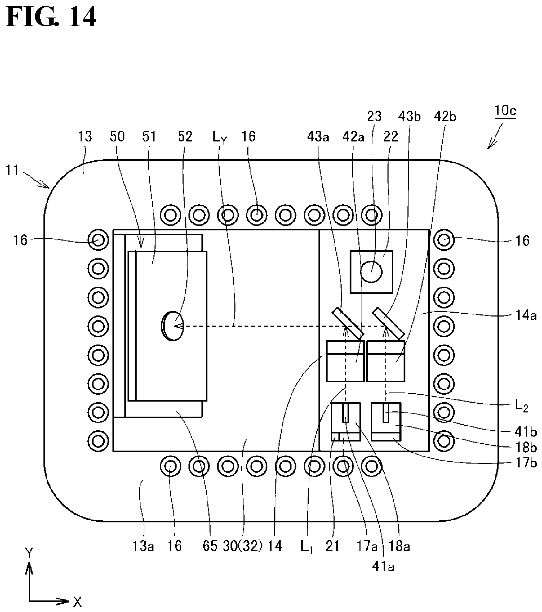

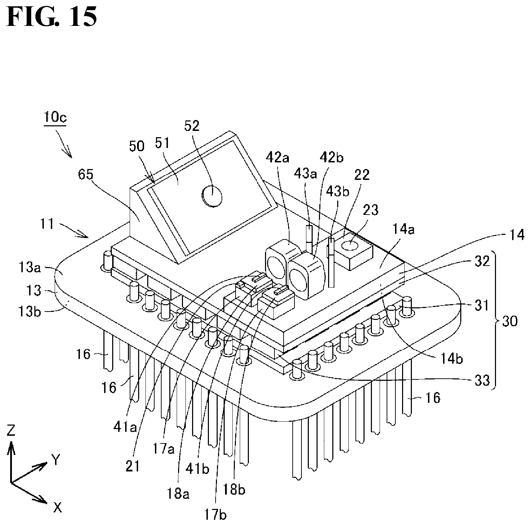

An embodiment 3, which is another embodiment, will be described. FIG. 13 is a schematic plan view of the optical module according to the embodiment 3. FIG. 14 is a schematic plan view showing a state where a cap of the optical module according to the embodiment 3 is removed. FIG. 15 is a perspective view of the appearance of the optical module shown in FIG. 14. The optical module according to the embodiment 3 basically has the similar configuration as that of the embodiment 2, and provides the same effects. However, the optical module of the embodiment 3 is different from the optical module of the embodiment 2 in that the optical module of the embodiment 3 includes a photodiode that receives reflected light.

Referring to FIGS. 13, 14 and 15, an optical module 10c of the embodiment 3 includes a photodiode 22 for receiving reflected light. Photodiode 22 has a light reception surface 23, and light reception surface 23 is arranged in the Z direction, that is, so as to face the surface on which transmission window 15 is provided. As a material of photodiode 22, for example, Si (silicon) is selected when the wavelength of first laser beam L₁ is 830 nm and the wavelength of second laser beam L₂ is 940 nm. Since the material of photodiode 22 is silicon, photodiode 22 has good characteristics. Photodiode 22 receives the reflected light which is the laser beam emitted to the outside of cap 12 as the protection container and reflected by the object.

Cap 12 is provided with an incidence window 19 for receiving reflected light. Photodiode 22 is arranged on electronic cooling module 30, and the temperature of photodiode 22 is adjusted. A controller 20 calculates the distance to the object based on the time when first laser beam L₁ and second laser beam L₂ are emitted and the time when photodiode 22 receives the reflected light.

According to the embodiment, controller 20 can calculate the distance to the object based on the difference between the time when first laser beam L₁ and second laser beam L₂ are emitted and the time when photodiode 22 receives the reflected light, and the speed of the laser beam (here, infrared light) which is previously known. Thus, the apparatus configuration can be made compact, and miniaturization can be easily achieved. Further, since the temperature of photodiode 22 is adjusted by electronic cooling module 30, it is possible to limit the change in performance of photodiode 22 due to the temperature, and to increase the accuracy of the distance to be measured.

In the above embodiment, a lens for condensing light may be provided as incidence window 19 itself, or inside or outside incidence window 19. In this way, the reflected light can be efficiently incident on light reception surface 23 of photodiode 22.

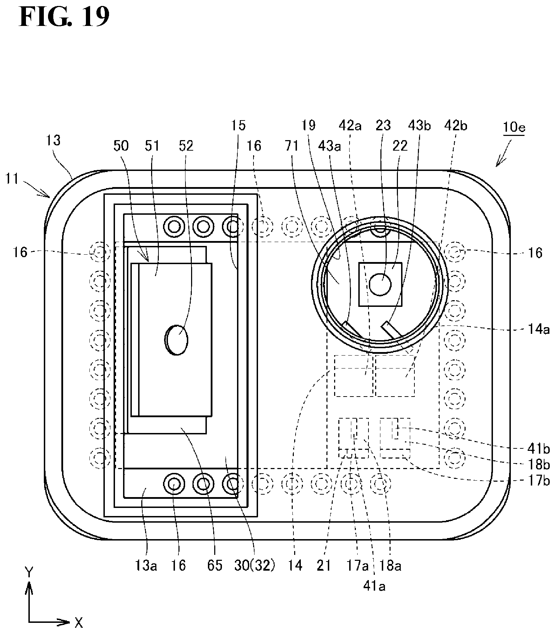

FIG. 18 is a schematic perspective view showing an optical module 10e in which a convex lens for condensing light is fitted in an incidence window. FIG. 19 is a schematic plan view of optical module 10e shown in FIG. 18. Referring to FIGS. 18 and 19, cap 12 as a protection container provided in optical module 10e according to the embodiment is provided with transmission window 15 and incidence window 19 which is circular as viewed in the Z direction and the reflected light is made incident on incidence window 19. A convex lens 71 is fitted to incidence window 19, and convex lens 71 is configured to condense the reflected light and cause the reflected light to be received by light reception surface 23 of photodiode 22. The reflected light reflected by the object and reaching convex lens 71 is condensed by convex lens 71 and reaches light reception surface 23 of photodiode 22. That is, light reception surface 23 of photodiode 22 receives the reflected light condensed by convex lens 71.

According to such a configuration, the reflected light from the object can be condensed by convex lens 71 and efficiently received by light reception surface 23 of photodiode 22, and thus the accuracy of the distance to be measured can be further improved.

In the above embodiment, transmission window 15 and incidence window 19 are provided separately, but the type of the window is not limited to this, and one integral window may be provided.

In the above embodiment, when the wavelength of first laser beam L₁ is 1310 nm and the wavelength of second laser beam L₂ is 1550 nm, InGaAs (indium gallium arsenide) may be used as the material of photodiode 22. Further, when the wavelength of first laser beam L₁ is 905 nm and the wavelength of second laser beam L₂ is 1550 nm, both photodiode 22 made of Si and photodiode 22 made of InGaAs may be mounted.

### (Embodiment 4)

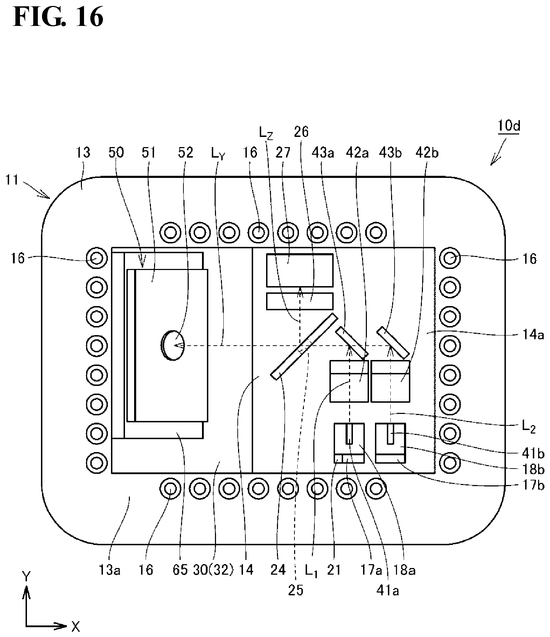

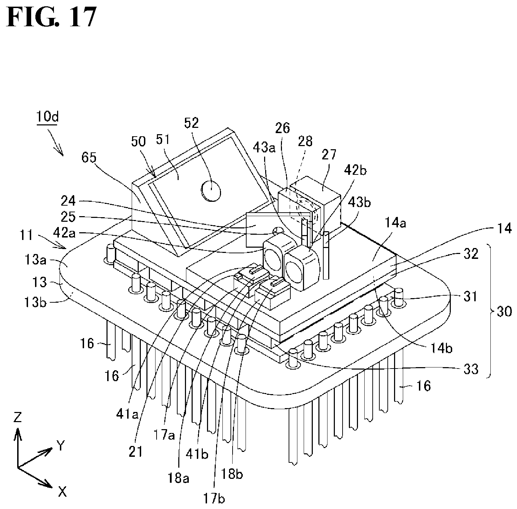

An embodiment 4, which is another embodiment, will be described. FIG. 16 is a schematic plan view showing a state where a cap of the optical module according to the embodiment 4 is removed. FIG. 17 is a perspective view of the optical module shown in FIG. 16. The optical module according to the embodiment 4 basically has the similar configuration as that of the embodiment 3, and provides the same effects. However, the optical module of the embodiment 4 is different from the optical module of the embodiment 3 in that the reflected light is made incident from the transmission window and the photodiode receives the reflected light reflected by the scanning mirror.

Referring to FIGS. 16 and 17, an optical module 10d of the embodiment 4 includes a reflecting mirror 24 having a through hole 25, a lens 26, and a photodiode 27 having a light reception surface 28. Reflecting mirror 24 is arranged on the optical path through which combined beam L_{Y} passes. Specifically, reflecting mirror 24 is arranged between first filter 43a and scanning mirror 52. Combined beam L_{Y} passes through through hole 25, emits from optical module 10d, and is reflected by the object. A reflected light L_{z} is reflected by scanning mirror 52 and travels in the direction opposite to combined beam L_{Y}. Reflected light L_{z} is reflected by reflecting mirror 24 to reach light reception surface 28 of photodiode 27. Photodiode 27 is arranged in the Y direction such that light reception surface 28 faces reflecting mirror 24. In the present embodiment, incidence window 19 shown in the embodiment 3 is not provided.

Combined beam L_{Y} reaches scanning mirror 52 through through hole 25. Reflected light L_{z} emitted from transmission window 15 and reflected by the object is incident from transmission window 15. Then, reflected light L_{z} is reflected by scanning mirror 52 and further reflected by reflecting mirror 24. In this case, since scanning mirror 52 is swinging, most of reflected light L_{z} is reflected toward the region of reflecting mirror 24 where through hole 25 is not provided, and thus reflected light L_{z} reaches light reception surface 28 of photodiode 27 via lens 26. In this way, photodiode 27 receives reflected light L_{z}. Controller 20 calculates the distance to the object based on the time when first laser beam L₁ and second laser beam L₂ are emitted and the time when reflected light L_{z} is received.

According to the present embodiment, it is possible to implement further miniaturization of the apparatus configuration. Further, since the disturbance light reaching light reception surface 28 of photodiode 27 is reduced, the SN ratio can be improved.

### (Other Embodiments)

In the above embodiment, the controller calculates the distance, but the method of calculating the distance is not limited to this, and the controller may control the pulse driving and the distance may be calculated by a device other than the controller.

In the above embodiment, the base on which the mirror driving mechanism is arranged is configured such that the mirror driving mechanism is arranged on the inclined surface provided on the base, but the configuration is not limited to this, and the base may have a surface parallel to the first surface of the support plate, and the mirror driving mechanism may be arranged on the parallel surface. In this case, another mirror may be arranged at an appropriate position so that the laser beam is incident on the scanning mirror of the mirror driving mechanism.

In the above embodiment, the laser diode and the mirror driving mechanism are arranged on the electronic cooling module, but the configuration is not limited to this, and a plurality of electronic cooling modules may be provided, and the electronic cooling module on which the laser diode is arranged and the electronic cooling module on which the mirror driving mechanism is arranged may be separately included. In this way, the temperature of each component can be strictly adjusted, and the distance can be measured with higher accuracy.

In the above embodiment, the laser diode is a multi-mode laser diode, but the laser diode is not limited to this, and a single-mode laser diode may be used. In particular, in the case described in the embodiment 2, a plurality of single-mode laser diodes is used, whereby output can be increased. Further, by using a single-mode laser diode, the beam diameter can be reduced, and a higher resolution can be achieved.

In the above embodiment, the laser diode that emits infrared light is used, but the laser diode is not limited to this, and laser diodes that emit visible light may be used for all or some of the plurality of laser diodes. For example, a laser diode that emits green light having a wavelength of 515 nm to 530 nm, which is not easily absorbed with water, or a laser diode that emits blue light having a wavelength of 430 nm to 460 nm, which is not easily absorbed with water, can be used for underwater distance measurement.

It should be understood that the embodiments disclosed herein are illustrative in all respects and not restrictive in any respect. The scope of the present invention is defined by the scope of the claims, not by the above description, and is intended to include all modifications within the meaning and scope equivalent to the scope of the claims.

### REFERENCE SIGNS LIST

10a, 10b, 10c, 10d, 10e optical module
11 base portion
12 cap (protection container)
13 support plate
13a first surface
13b second surface
14 base plate
14a first main surface
14b second main surface
15 transmission window
16 lead pin
17a block portion (first block portion)
17b block portion (second block portion)
18a mount portion (first mount portion)
18b mount portion (second mount portion)
19 incidence window
20 controller
21 thermistor
22, 27 photodiode
23, 28 light reception surface
24 reflecting mirror
25 through hole
26 lens
30 electronic cooling module (electronic temperature adjustment module)
31 heat dissipation plate
32 heat absorption plate
33 semiconductor pillar
41a laser diode (first laser diode)
41b laser diode (second laser diode)
42a lens (first lens)
42b lens (second lens)
43a filter (first filter)
43b filter (second filter)
44, 45 first laser beam
50 mirror driving mechanism (scanning portion)
51 frame portion
52 scanning mirror
53 support portion
54a, 54b shaft portion
55 reflection surface
56a, 56b, 56c, 56d, 64a, 64b, 64c, 64d, 64e, 64f, 64g, 64h piezoelectric element
57a first through hole
57b second through hole
58 attachment portion
59a first swing axis
59b second swing axis
61a, 61b, 61c, 61d, 61e, 61f, 61g, 61h first portion
62a, 62b, 62c, 62d, 62e, 62f second portion
63a, 63b coupling portion
63c, 63d connecting portion
65 base
71 convex lens
D₁, D₂, X, Y, Z arrow
θₕ angle
L₁ first laser beam
L₂ second laser beam
L_{X} first laser beam
Ly combined beam
L_{R}, L_{S}, L_{T} scanning light
L_{Z} reflected light
R, W₁, W₂, W₃ diameter
S₁, S₂ distance
θ angle (angle resolution)

## Claims

1. An optical module comprising:
a laser diode configured to emit a laser beam;
a scanning portion including a reflecting mirror configured to reflect the laser beam, the scanning portion being configured to output the laser beam to an outside by swinging the reflecting mirror;
a protection container having a transmission window through which the laser beam is transmitted, the protection container surrounding the laser diode and the scanning portion;
a controller configured to control such that the laser beam becomes a pulse wave; and
an electronic temperature adjustment module configured to adjust a temperature of the laser diode and a temperature of the scanning portion.

2. The optical module according to claim 1,
wherein a duty ratio of the pulse wave is more than 0.1% and 10% or less.

3. The optical module according to claim 1 or claim 2,
wherein the laser diode includes a plurality of laser diodes, and
wherein the optical module further comprises a filter configured to combine laser beams emitted from the plurality of laser diodes.

4. The optical module according to any one of claim 1 to claim 3,
wherein at least one of the plurality of laser diodes is configured to emit infrared light.

5. The optical module according to any one of claim 1 to claim 4,
wherein at least one of the plurality of laser diodes is configured to emit visible light.

6. The optical module according to any one of claim 1 to claim 5, further comprising:
a lens configured to adjust a spot size of the laser beam.

7. The optical module according to any one of claim 1 to claim 6,
wherein an emission area width of the laser beam is 50 µm or less.

8. The optical module according to any one of claim 1 to claim 7,
wherein an emission area width of the laser beam is 30 µm or less.

9. The optical module according to any one of claim 1 to claim 8, further comprising:
a photodiode configured to receive reflected light, the reflected light being the laser beam that is output to an outside of the protection container and reflected by an object.

10. The optical module according to claim 9,
wherein the photodiode is configured to receive reflected light from the reflecting mirror.

11. The optical module according to claim 9 or claim 10,
wherein the protection container is provided with an incidence window on which the reflected light is made incident, and
wherein a convex lens is fitted to the incidence window, the convex lens being configured to condense the reflected light and cause the reflected light to be received by a light reception surface of the photodiode.

12. The optical module according to any one of claim 9 to claim 11,
wherein a temperature of the photodiode is adjusted by the electronic temperature adjustment module.

13. The optical module according to any one of claim 9 to claim 12,
wherein the controller is configured to calculate a distance to the object based on a time when the laser beam is emitted and a time when the photodiode receives the reflected light.
